# EUROPEAN PATENT APPLICATION

(11) **EP 4 503 893 A1**
(43) Date of publication of application: **05.02.2025**
(21) Application number: 23773759.8
(22) Date of filing: 18.03.2023
(51) Int. Cl.: H10K 59/10

(54) **SILICON-BASED MICRO-DISPLAY, DISPLAY MODULE AND ELECTRONIC DEVICE**

(30) Priority: 25.03.2022 CN 202210307888
(71) Applicant: Beijing Zitiao Network Technology Co., Ltd., Beijing 100190 (CN); Lemon Inc., Grand Cayman, KY1-1205 (KY)
(72) Inventor: LI, Xiaokai, Beijing 100028 (CN); LI, Yongjun, Los Angeles, California 90066 (US)
(74) Representative: Dentons UK and Middle East LLP
(86) International application number: PCT/CN2023/082368
(87) International publication number: WO 2023/179511

(57) **Abstract**

There is provided a silicon-based microdisplay, a display module and an electronic device, including a silicon-based backboard and an OLED device; the silicon-based backboard include a top edge, a base edge and two side edges opposite to each other, the top edge and the base edge are connected to the side edges respectively, and the base edge is connected to the side edges to form a base angle; the silicon-based backboard is provided with an active region and a driver circuit region, the OLED device is deposited in the active region, and the driver circuit region is configured to make a display driver circuit; wherein, the active region is located in a middle of the silicon-based backboard, and the active region is arranged to expose the silicon-based backboard within a first predetermined range from the base angle, the exposed silicon-based backboard within the first predetermined range from the base angle is used as a first supplementary region, and the first supplementary region is used as a part or all of the driver circuit region. Occupation of a region directly below the active region is reduced, thereby reducing an impact on the active region, increasing an effective display size and an effective display area of the active region, and improving a display effect.

## Description

### CROSS REFERENCE

This disclosure claims priority of Chinese Patent Application No. 202210307888.8 submitted to the Chinese Patent Office on March 25, 2022 and entitled "SILICON-BASED MICRODISPLAY, DISPLAY MODULE AND ELECTRONIC DEVICE", which is incorporated herein by reference in its entirety.

### FIELD

Embodiments of the present disclosure relate to the field of displaying, and in particular to a silicon-based microdisplay, a display module and an electronic device.

### BACKGROUND

An OLED on silicon microdisplay is an active organic light-emitting diode display device made by combining a Complementary Metal Oxide Semiconductor (CMOS) technology and an Organic Light Emitting Diodes (OLED) technology, using monocrystalline silicon as an active driving backboard. It has many excellent characteristics such as a high pixel density, a high integration, a small volume, and a low power consumption, etc. Therefore, it is very suitable for applying in a Virtual Reality (VR) device to provide an user with a better visual experience.

Resolution of a microdisplay is mainly affected by a size of an active region. In the prior art, since the OLED on silicon microdisplay has a strict restriction on a device volume when applied to the VR device, and the area of the backboard is small, at the same time, a corresponding display driver circuit further needs to be provided on the backboard, it leads to reduction of the size of the active region, thus affecting the resolution and a visual range of the microdisplay, resulting in poor screen appearance, low immersion and other problems of the VR device that displays an image through the microdisplay.

### SUMMARY

The embodiments of the present disclosure provide a silicon-based microdisplay, a display module and an electronic device to overcome the problems of small resolution and visual range of the microdisplay due to the small size of the active region.

In a first aspect, the embodiments of the present disclosure provide a silicon-based microdisplay comprising a silicon-based backboard and an OLED device; the silicon-based backboard comprises a top edge, a base edge and two side edges opposite to each other, the top edge and the base edge are connected to the side edges respectively, and the base edge is connected to the side edges to form a base angle; the silicon-based backboard is provided with an active region and a driver circuit region, the OLED device is deposited in the active region, and the driver circuit region is configured to make a display driver circuit; Wherein, the active region is located in a middle of the silicon-based backboard, and the active region is arranged to expose the silicon-based backboard within a first predetermined range from the base angle, the exposed silicon-based backboard within the first predetermined range from the base angle is used as a first supplementary region, and the first supplementary region is used as a part or all of the driver circuit region.

**In** a second aspect, the embodiments of the present disclosure provide a display module comprising an optical device and the silicon-based microdisplay of the above first aspect and various possible designs of the first aspect, the optical device and the silicon-based microdisplay are disposed in parallel, and the optical device is located on a side of the silicon-based microdisplay on which the OLED device is deposited.

In a third aspect, the embodiments of the present disclosure provide an electronic device comprising the silicon-based microdisplay of the above first aspect and the various possible designs in the first aspect.

The embodiments provide the silicon-based microdisplay, the display module and the electronic device, including a silicon-based backboard and an OLED device; the silicon-based backboard comprises a top edge, a base edge and two side edges opposite to each other, the top edge and the base edge are connected to the side edge respectively, and the base edge is connected to the side edge to form a base angle; the silicon-based backboard is provided with an active region and a driver circuit region, the OLED device is deposited in the active region, and the driver circuit region is configured to make a display driver circuit; wherein, the active region is located in a middle of the silicon-based backboard, and the active region is arranged to expose the silicon-based backboard within the first predetermined range from the base angle, the exposed silicon-based backboard within the first predetermined range from the base angle is used as a first supplementary region, and the first supplementary region is used as a part or all of the driver circuit region. Through setting up the active region, the first supplementary region is reserved in a corner direction of the silicon-based backboard, so that the driver circuit region can be disposed in the first supplementary region, reducing occupation of a region directly below the active region, thereby reducing an impact on the active region, increasing an effective display size and an effective display area of the active region, and improving a display effect.

### BRIEF DESCRIPTION OF THE DRAWINGS

In order to more clearly describe the embodiments of the present disclosure or the technical solution in the prior art, the following will briefly introduce the drawings needed in the embodiments or the prior art description. It is obvious that the drawings in the following description are some embodiments of the present disclosure. For ordinary technicians in the art, they can also obtain other drawings from these drawings without paying creative labor.
FIG. 1 is a structural diagram of a VR device provided by the embodiments of the present disclosure;
FIG. 2 is a structural diagram of a silicon-based microdisplay in the prior art;
FIG. 3 is a structural diagram of a silicon-based microdisplay provided by the embodiments of the present disclosure;
FIG. 4 is a comparison diagram of an effective display region optimized for the prior art provided by the embodiments of the present disclosure;
FIG. 5 is a structural diagram of another silicon-based microdisplay provided by the embodiments of the present disclosure;
FIG. 6 is a structural diagram of another silicon-based microdisplay provided by the embodiments of the present disclosure;
FIG. 7 is a schematic diagram of a display module provided by the embodiments of the present disclosure;
FIG. 8 is a schematic diagram of a hardware structure of an electronic device provided by the embodiments of the present disclosure.

### DETAILED DESCRIPTION

In order to make the purpose, technical solution and advantages of the embodiments of the present disclosure clearer, the technical solution in the embodiments of the present disclosure will be described clearly and completely below in combination with drawings in the embodiments of the present disclosure. Obviously, the described embodiments is a part of the embodiments of the present disclosure, not all of the embodiments. Based on the embodiments in the disclosure, all other embodiments obtained by ordinary technicians in the art without doing creative work fall within the scope of the protection of the present disclosure.

An application scenario of the embodiments of the present disclosure is explained below:

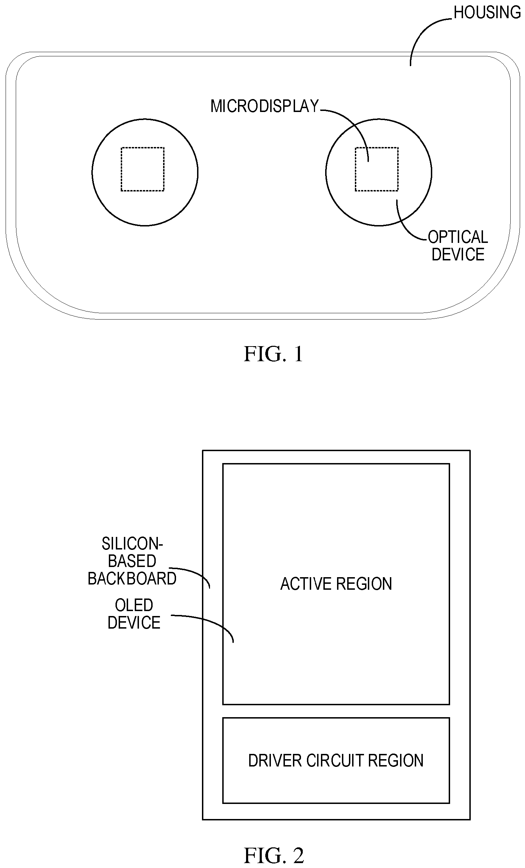

FIG. 1 is a structural diagram of a VR device provided by the embodiments of the present disclosure. As shown in FIG. 1, by way of example, the VR device is for example VR glasses composed of a microdisplay, an optical device, and a housing. Of course, it can be understood that the VR device further includes a processor, a controller, a sensor, and other components, which are not shown in the figure. The microdisplay in FIG. 1 can be a silicon-based microdisplay (i.e. an OLED on silicon microdisplay) provided by the embodiments of the present disclosure. After receiving an image source, the silicon-based microdisplay emits light for displaying through an OLED device, after the light passes through the optical device (for example including a magnifying lens), the light enters an eye of a user wearing the VR glasses to complete an image display process.

In an application scenario of a display device as the VR device, the silicon-based microdisplay is integrated with the OLED device and a drive control circuit at the same time, reducing an external wiring of the device, increasing reliability, and realizing lightweight. However, at the same time, due to a large number and density of integrated circuits on the silicon-based microdisplay, there are limitations in design positions between the integrated circuits. FIG. 2 is a structural diagram of a silicon-based microdisplay in the prior art. As shown in FIG. 2, the silicon-based microdisplay includes a silicon-based backboard and the OLED device, wherein the OLED device is deposited in the active region. Both the silicon-based backboard and the active region are rectangular. A driver circuit region is arranged in a bottom region of the silicon-based backboard, and configured to make a display driver circuit. The active region is disposed above an installation region of the device. It can be seen from FIG. 2 that since a lower part of the silicon-based backboard needs to arrange the driver circuit region to make the display driver circuit, the active region can only be disposed in a region above the driver circuit region, resulting in a size of the active region being limited.

At the same time, in the application scenario of the display device as the VR device, since a light-emitting area of the microdisplay is very small, and the light will be projected into the eye of the user after passing through the optical device (for example magnifying through the lens) , an effective display area of the active region of the microdisplay will be limited by the optical device, resulting in that the OLED device in four corner regions of the active region of the microdisplay cannot provide effective display, that is, the four corner regions of the active region are invalid display regions, resulting in wastage of a space of the backboard.

To solve the above problems, the embodiments of the present disclosure provide a silicon-based microdisplay including a silicon-based backboard and an OLED device. By way of example, the silicon-based backboard, that is, a driver backboard, is made of monocrystalline silicon material and fabricated with standard CMOS process to form a pixel circuit, a row and column driver circuit and other functional circuits required by the OLED on silicon microdisplay. By way of example, the silicon-based backboard may be a silicon-based die or a silicon-based panel.

The silicon-based backboard includes a top edge, a base edge and two side edges opposite to each other, the top edge and the base edge are connected to the side edges respectively, and the base edge is connected to the side edges to form a base angle. The silicon-based backboard is provided with an active region and a driver circuit region, and the OLED device is deposited in the active region. Specifically, by way of example, a highly reflective metal is usually made in a top metal of a CMOS circuit as an anode of the OLED device. The OLED device usually includes a hole transport layer, a light-emitting layer, an electron transport layer, an electron injection layer, and a translucent top electrode. The driver circuit region is configured to make a display driver circuit. By way of example, the display driver circuit is, for example, a display driver chip (Display Driver Integrated Circuit, DDIC). The display driver chip is fabricated on the silicon-based backboard by etching, etc.

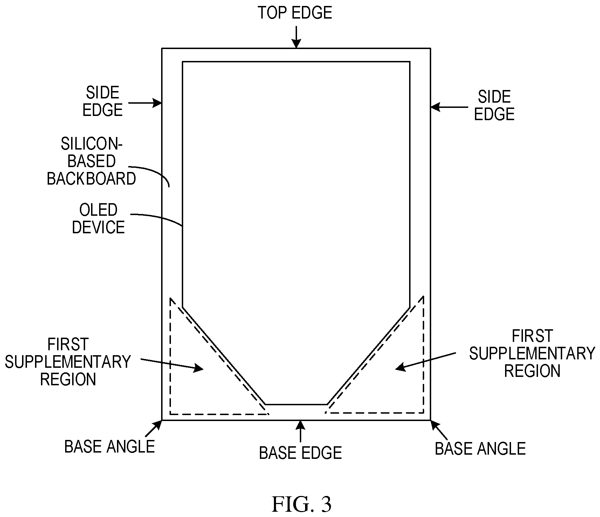

FIG. 3 is a structural diagram of a silicon-based microdisplay provided by the embodiments of the present disclosure. Referring to FIG. 3, the active region is located in a middle of the silicon-based backboard, and the active region is arranged to expose the silicon-based backboard within a first predetermined range from the base angle. The exposed silicon-based backboard within the first predetermined range from the base angle is used as a first supplementary region, and the first supplementary region is used as all of the driver circuit region.

Referring to the structural diagram of the silicon-based microdisplay in the prior art shown in FIG. 2, in this embodiment, the driver circuit region is no longer disposed at the bottom of the silicon-based backboard, therefore the size of the active region will not be limited, and a vertical size of the active region extends to the bottom region of the silicon-based backboard. At the same time, compared with the rectangular active region shown in FIG. 2, the active region provided in this embodiment is irregularly shaped, that is, the silicon-based backboard within the first predetermined range from the base angle is exposed, as the first supplementary region, the first supplementary region is located at two foot positions of the rectangular silicon-based backboard, and the first supplementary region is used as the driver circuit region to realize the fabrication of the display driver circuit. The first predetermined range can be determined by a predetermined size, for example, the first supplementary region is a triangle, and the first predetermined range of the triangle can be determined according to a preset side length of a first right-angle side and a second right-angle side. Specifically, the above predetermined size can be determined according to a size of the optical device, a distance between the optical device and the silicon-based microdisplay and other factors, which will not be described here.

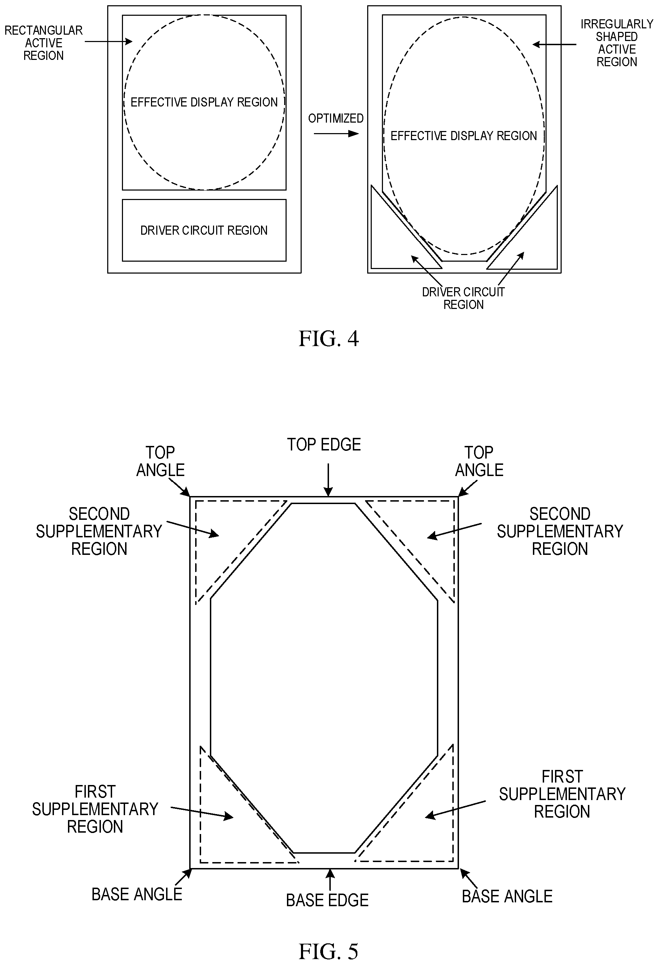

In this embodiment, in order to expose the first supplementary region, the irregularly shaped active region reduces a coverage area of the corner region of the silicon-based backboard. However, since the active region of the corner region of the silicon-based backboard is the invalid display region, an effective display area of the active region will not be reduced. At the same time, since the driver circuit region moves from the bottom of the silicon-based backboard to the first supplementary region, a longitudinal size of the active region (compared with the prior art solution shown in FIG. 2) is increased. FIG. 4 is a comparison diagram of an effective display region optimized for the prior art provided by the embodiments of the present disclosure. As shown in FIG. 4, compared with the rectangular active region in the prior art, the effective display area of the irregularly shaped active region provided by the embodiments of the present disclosure is increased, reducing an invalid display area, fully utilizing the space of the backboard, and improving a space utilization rate of the silicon-based backboard.

Optionally, the top edge of the silicon-based backboard is connected to the side edges of the silicon-based backboard to form a top angle, the active region is arranged to expose the silicon-based backboard within a second predetermined range from the top angle. The exposed silicon-based backboard within the second predetermined range from the top angle is used as a second supplementary region. When the first supplementary region is used as a part of the driver circuit region, the second supplementary region and the first supplementary region are used as the driver circuit region.

In a possible implementation mode, the active region on the silicon-based backboard is an octagon. A long axis of the octagonal active region is close to the top edge and base edge of the silicon-based backboard, and a short axis of the octagonal active region is close to the two side edges of the silicon-based backboard, thereby maximizing the effective display area of the active region. Compared with the rectangular active region in the prior art, the octagonal active region further exposes the silicon-based backboard within the second predetermined range from the top angle. FIG. 5 is a structural diagram of another silicon-based microdisplay provided by the embodiments of the present disclosure. As shown in FIG. 5, the exposed silicon-based backboard within the second predetermined range from the top angle is used as the second supplementary region. On the one hand, an area of the active region in a top angle region is reduced, which can correspondingly reduce an area of depositing the OLED device, reduce consumption of a process material, and reduce cost. Optionally, on the other hand, the driver circuit region can be dispersedly disposed in the first supplementary region and the second supplementary region, thereby reducing respective areas of the first supplementary region and the second supplementary region, thereby increasing redundancy of the effective display area and further improving a visual range of the active region.

Optionally, referring to FIG. 5, in addition to the octagon, the active region can be symmetric polygons with even number of sides, for example a diamond, a hexagon and a dodecagon, which will not be described in detail here.

Optionally, the active region can be an ellipse, wherein a long axis distance and a short axis distance of the elliptical active region are determined by a size of the optical device. For example, the long axis distance and the short axis distance of the active region are determined by a lens size of an optical lens and a distance between the optical lens and the silicon-based microdisplay.

Optionally, the driver circuit region further includes a spacer region between a bottom edge of the active region and the base edge, and the spacer region is provided with a functional circuit. By way of example, the spacer region is provided with silicon-based backboard pins (pad), that is, the silicon-based backboard pins are machined within the spacer region. The silicon-based backboard pins are an interface for data exchange with other circuits. By arranging the spacer region between the bottom edge and the base edge, and making the silicon-based backboard pins in the spacer region, it is convenient for data transmission with a peripheral circuit, and makes full use of the backboard space.

Optionally, the base edge is connected to the two side edges to form a first base angle and a second base angle respectively. The first supplementary region includes a first sub-region disposed at the first base angle and a second sub-region disposed at the second base angle. One of the first sub-region and the second sub-region is configured to arrange a gamma coding circuit, and the other one of the first sub-region and the second sub-region is configured to arrange a power management circuit.

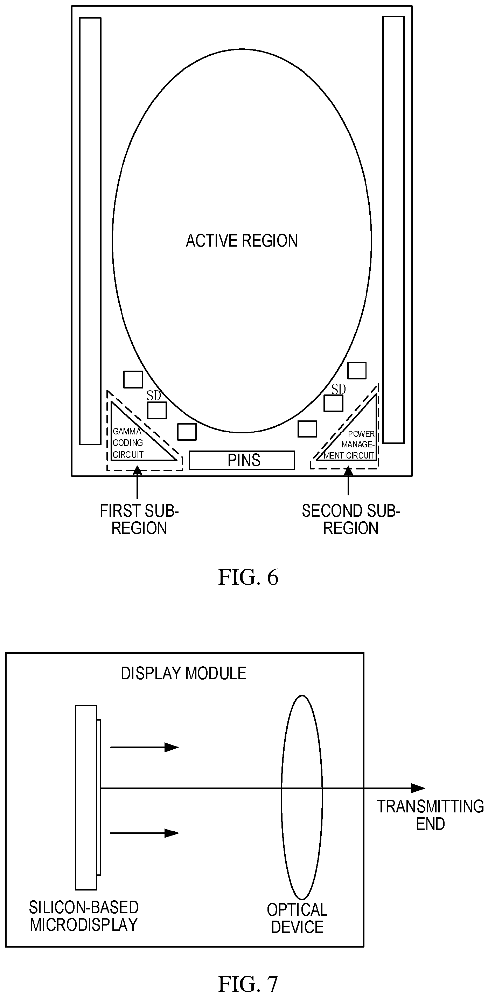

FIG. 6 is a structural diagram of another silicon-based microdisplay provided by the embodiments of the present disclosure. As shown in FIG. 6, the active region is the ellipse. The active region exposes the first sub-region and the second sub-region of the silicon-based backboard, the first sub-region is located at the first base angle, the second sub-region is located at the second base angle. The gamma coding circuit (Gamma shown in the figure) is disposed within the first sub-region, and the power management circuit (Power shown in the figure) is disposed within the second sub-region. The gamma coding circuit is configured to perform gamma encoding on an image. The purpose of the gamma encoding is to compensate a characteristic of human vision, thereby maximizing the use of data bits representing black and white according to human perception of light or black and white. The power management circuit includes a power management module and a level conversion module, which are used to supply power for the silicon-based microdisplay and perform level conversion respectively. A specific implementation mode of the gamma coding circuit and the power management circuit are the prior art, and will not be described here.

Optionally, a source driver circuit (Source Driver, SD shown in the figure) is disposed between the gamma coding circuit and the bottom edge of the active region, and/or between the power management circuit and the bottom edge of the active region. By way of example, as shown in FIG. 6, the source driver circuit includes a plurality of sub-circuits, dispersedly disposed at an outer side of the bottom of the active region. The source driver circuit is configured to drive a directional control signal of the active region.

The source driver circuit includes at least one of: a pixel processing circuit, a pixel cache circuit, a logic circuit and a timing circuit. The specific implementation method of the source driver circuit is the prior art known to those skilled in the art, and will not be described here.

**Optionally,** an array row driver circuit (Gate in Panel, GIP shown in the figure) is disposed between the side edge and a side edge of the active region. The array row driver circuit needs to be disposed on both sides of the active region. Through a design of the active region, a space is reserved between the side edge of the active region and the side edge to realize the fabrication of the array row driver circuit, making full use of the backboard space and improving an overall integration density of a device.

It should be noted that the above embodiment is only a possible implementation of the display driver circuit (DDIC) in the driver circuit region (mainly involving the implementation of analog and digital-analog hybrid modules in the DDIC). On this basis, the display driver circuit within the driver circuit region can further include modules for realizing other functions, for example a digital function module for realizing a digital function. The digital function module can be realized by another chip in the driver circuit region and linked in a way of COF (chip on film) or COC (chip on chip). In addition, according to a process selected for the specific backboard IC, if higher manufacturing process is adopted (for example below 55nm), more digital functions for example a timing module, a logic control module and an image processing module for screen correction compensation can be integrated in the first supplementary region (including the first sub-region, the second sub-region, etc.) in the lower part of FIG. 6, therefore further improving the utilization of the backboard space and improving circuit integration.

FIG. 7 is a schematic diagram of a display module provided by the embodiments of the present disclosure. As shown in FIG. 7, the display module includes the optical device, and in the silicon-based microdisplay provided by any embodiments as shown in FIGS. 3 to 6, the optical device and the silicon-based microdisplay are disposed in parallel, and the optical device is located on a side of the silicon-based microdisplay on which the OLED device is deposited. The display module has a transmitting end, and a side of the optical device away from the silicon-based microdisplay is the transmitting end of the display module. When the silicon-based microdisplay emits light, the light is emitted to the transmitting end through the optical device, and emitted outward from the transmitting end and projected to the eye of the user, completing a process of the image display.

By way of example, the optical device includes a lens.

Optionally, a projection contour of the lens on the silicon-based microdisplay is an ellipse.

Optionally, the projection contour of the lens on the silicon-based microdisplay is the same as a contour shape of the active region of the silicon-based microdisplay.

The embodiments of the present disclosure provide an electronic device including the silicon-based microdisplay provided by any embodiments of FIGS 3 to 6; alternatively, including the display module as shown in FIG. 7.

**Optionally,** the electronic device is a VR display device such as a VR helmet, VR glasses, etc.

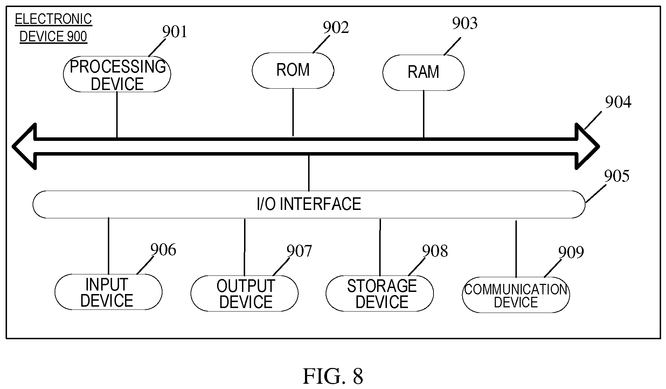

Referring to FIG. 8, it shows a schematic diagram of a hardware structure of an electronic device 900 provided by the embodiments of the present disclosure. The electronic device 900 can be a terminal device or a server. The terminal device may include but are not limited to a mobile terminal such as a VR head-mounted display, a mobile phone, a laptop, a digital broadcast receiver, a Personal Digital Assistant (PDA), a Portable Android Device (PAD), a Portable Media Player (PMP), a vehicle terminal (such as a vehicle navigation terminal), and so on, as well as a fixed terminal such as a digital TV, a desktop computer, and so on. The electronic device shown in FIG. 8 is only an example, and should not impose any restrictions on the function and scope of use of the embodiments of the present disclosure.

As shown in FIG. 8, the electronic device 900 can include a processing device (such as a central processor, a graphics processor, etc.) 901, which can perform various appropriate actions and processes according to the program stored in a read only memory (ROM) 902 or a program loaded from a storage device 908 into a random access memory (RAM) 903. The RAM 903 further stores various programs and data required for the operation of the electronic device 900. The processing device 901, ROM 902, and RAM 903 are connected to each other through bus 904. A input/output (I/O) interface 905 is further connected to the bus 904.

**Typically,** the following device can be connected to I/O interface 905: an input device 906 including, for example, a touch screen, a touchpad, a keyboard, a mouse, a camera, a microphone, an accelerometer, a gyroscope, etc; an output device 907 including, for example, the silicon-based microdisplay or a display component provided in the embodiments of the present disclosure, a loudspeaker, a vibrator, etc; a storage device 908 including, for example, a magnetic tape, a hard drive, etc; and a communication device 909. The communication device 909 may allow the electronic device 900 to achieve wireless or wired communication with other devices to exchange data. Although FIG. 8 shows an electronic device 900 with various devices, it should be understood that it is not required to implement or have all the devices shown. It can be implemented or equipped with more or fewer devices as an alternative.

In a first aspect, according to a or more embodiments of the present disclosure, provide a silicon-based microdisplay including: a silicon-based backboard and an OLED device; the silicon-based backboard includes a top edge, a base edge and two side edges opposite to each other. The top edge and the base edge are connected to the side edges respectively, and the base edge is connected to the side edges to form a base angle. The silicon-based backboard is provided with an active region and a driver circuit region, the OLED device is deposited in the active region, and the driver circuit region is configured to make a display driver circuit; the active region is located in a middle of the silicon-based backboard, and the active region is arranged to expose the silicon-based backboard within a first predetermined range from the base angle. The exposed silicon-based backboard within the first predetermined range from the base angle is used as a first supplementary region, and the first supplementary region is used as a part or all of the driver circuit region.

According to a or more embodiments of the present disclosure, the top edge is connected to the side edges to form a top angle, the active region is arranged to expose the silicon-based backboard within a second predetermined range from the top angle. The exposed silicon-based backboard within the second predetermined range from the top angle is used as a second supplementary region, and when the first supplementary region is used as a part of the driver circuit region, the second supplementary region and the first supplementary region are used as the driver circuit region.

According to a or more embodiments of the present disclosure, a shape of the active region is any one of an ellipse, a hexagon, an octagon, or a diamond.

According to a or more embodiments of the present disclosure, the driver circuit region further includes a spacer region between a bottom edge of the active region and the base edge.

According to a or more embodiments of the present disclosure, the spacer region is provided with silicon-based backboard pins.

According to a or more embodiments of the present disclosure, the base edge is connected to the two side edges to form a first base angle and a second base angle respectively. The first supplementary region includes a first sub-region disposed at the first base angle and a second sub-region disposed at the second base angle. One of the first sub-region and the second sub-region is configured to arrange a gamma coding circuit, and the other one of the first sub-region and the second sub-region is configured to arrange a power management circuit.

According to a or more embodiments of the present disclosure, a source driver circuit is disposed between the gamma coding circuit and the bottom edge of the active region, and/or between the power management circuit and the bottom edge of the active region.

According to a or more embodiments of the present disclosure, the source driver circuit includes at least one of: a pixel processing circuit, a pixel cache circuit, a logic circuit, and a timing circuit.

According to a or more embodiments of the present disclosure, an array row driver circuit is disposed between the side edge and a side edge of the active region.

According to a or more embodiments of the present disclosure, the silicon-based backboard includes a silicon-based wafer or a silicon-based panel.

In a second aspect, according to a or more embodiments of the present disclosure, provide a display module including an optical device and the silicon-based microdisplay of the above first aspect and various possible designs of the first aspect. The optical device and the silicon-based microdisplay are disposed in parallel, and the optical device is located on a side of the silicon-based microdisplay on which the OLED device is deposited.

In a third aspect, according to a or more embodiments of the present disclosure, provide an electronic device including the silicon-based microdisplay of the above first aspect and the various possible designs in the first aspect.

The above description is only an explanation of better embodiments of the present disclosure and the applied technical principles. Technicians in this field should understand that the scope of disclosure referred to in this disclosure is not limited to technical solutions formed by specific combinations of the aforementioned technical features, and should further cover other technical solutions formed by arbitrary combinations of the aforementioned technical features or their equivalent features without departing from the disclosed concept. For example, a technical solution formed by replacing the above features with (but not limited to) technical features with similar functions disclosed in this disclosure.

Furthermore, although the operations are depicted in a specific order, this should not be understood as requiring them to be executed in the specific order shown or in sequential order. In certain environments, multitasking and parallel processing may be advantageous. Similarly, although several specific implementation details are included in the above discussion, these should not be interpreted as limitations on the scope of this disclosure. Certain features described in the context of a separate embodiments may further be implemented in a single embodiment in combination. Conversely, various features described in the context of a single embodiments may further be implemented in multiple embodiments individually or in any suitable sub combination.

Although the subject matter has been described in terms specific to the structural features and/or method logic actions, it should be understood that the subject matter defined in the attached claims are not necessarily limited to the specific features or actions described above. On the contrary, the specific features and actions described above are only examples of realizing the claims.

## Claims

1. A silicon-based microdisplay comprising: a silicon-based backboard and an OLED device;
the silicon-based backboard comprising a top edge, a base edge and two side edges opposite to each other, the top edge and the base edge being connected to the side edges respectively, and the base edge being connected to the side edges to form a base angle;
the silicon-based backboard being provided with an active region and a driver circuit region, the OLED device being deposited in the active region, and the driver circuit region being configured to make a display driver circuit;
wherein, the active region is located in a middle of the silicon-based backboard, and the active region is arranged to expose the silicon-based backboard within a first predetermined range from the base angle, the exposed silicon-based backboard within the first predetermined range from the base angle is used as a first supplementary region, and the first supplementary region is used as a part or all of the driver circuit region.

2. The silicon-based microdisplay according to claim 1, wherein the top edge is connected to the side edges to form a top angle, the active region is arranged to expose the silicon-based backboard within a second predetermined range from the top angle, the exposed silicon-based backboard within the second predetermined range from the top angle is used as a second supplementary region, and when the first supplementary region is used as a part of the driver circuit region, the second supplementary region and the first supplementary region are used as the driver circuit region.

3. The silicon-based microdisplay according to claim 1 or 2, wherein a shape of the active region is any one of an ellipse, a hexagon, an octagon, or a diamond.

4. The silicon-based microdisplay according to any one of claims 1-3, wherein the driver circuit region further comprises a spacer region between a bottom edge of the active region and the base edge.

5. The silicon-based microdisplay according to claim 4, wherein the spacer region is provided with silicon-based backboard pins.

6. The silicon-based microdisplay according to any one of claims 1-4, wherein the base edge is connected to the two side edges to form a first base angle and a second base angle respectively, the first supplementary region comprises a first sub-region disposed at the first base angle and a second sub-region disposed at the second base angle, one of the first sub-region and the second sub-region is configured to arrange a gamma coding circuit, and the other one of the first sub-region and the second sub-region is configured to arrange a power management circuit.

7. The silicon-based microdisplay according to claim 6, wherein a source driver circuit is disposed between the gamma coding circuit and a bottom edge of the active region, and/or between the power management circuit and the bottom edge of the active region.

8. The silicon-based microdisplay according to claim 7, wherein the source driver circuit comprises at least one of:
a pixel processing circuit, a pixel cache circuit, a logic circuit, and a timing circuit.

9. The silicon-based microdisplay according to any one of claims 1-8, wherein an array row driver circuit is disposed between the side edge and a side edge of the active region.

10. The silicon-based microdisplay according to any one of claims 1-9, wherein the silicon-based backboard comprises a silicon-based wafer or a silicon-based panel.

11. A display module comprising the silicon-based microdisplay according to any one of claims 1-10 and an optical device, the optical device and the silicon-based microdisplay are disposed in parallel, and the optical device is located on a side of the silicon-based microdisplay on which the OLED device is deposited.

12. An electronic device comprising the silicon-based microdisplay according to any one of claims 1-10.
